# EUROPEAN PATENT APPLICATION

(11) **EP 3 352 536 A1**
(43) Date of publication of application: **25.07.2018**
(21) Application number: 18151776.4
(22) Date of filing: 16.01.2018
(51) Int. Cl.: H05K 3/00, H05K 1/18

(54) **A MOUNTING STRUCTURE FOR LIGHT RADIATION SOURCES, CORRESPONDING LIGHTING DEVICE AND METHOD OF USE**

(30) Priority: 18.01.2017 IT 201700005125
(71) Applicant: OSRAM GmbH, 80807 München (DE); Osram S.p.A. - Societa' Riunite Osram Edison Clerici, 20126 Milano (IT)
(72) Inventor: BOBBO, Simon, 30035 Mirano (Venezia) (IT); BALDO, Lorenzo, 31040 Giavera del Montello (Treviso) (IT); VOLPATO, Luca, 31022 Preganziol (Treviso) (IT); BEER, Martin, 93053 Regensburg (DE)
(74) Representative: Bosotti, Luciano

(57) **Abstract**

A mounting structure, e.g. stripe-like or rod-like, for electrically powered light radiation sources (L), e.g. LED sources, includes an elongated substrate (12) having therealong a distribution of mounting units (U1, U2) for electrically powered light radiation sources (L).

Said mounting units include first (141) and second (142) electrical contact end pads between which it is possible to apply a power supply (LED+, LED-). Between the first (141) and the second (142) electrical contact end pads, there are interposed one or more light radiation source mounting positions (120). The elongated substrate (12) includes, between mutually facing electrical contact end pads of adjacent mounting units, severable portions (K; K1, K2) of substrate (12) .

## Description

### Technical Field

The present description relates to electrically powered lighting devices.

One or more embodiments may refer to mounting structures for lighting devices employing solid-state light radiation sources, e.g. LED sources.

### Technological Background

On the market there are available lighting modules having point-like sources (e.g. LED sources) having a support structure including an e.g. flexible stripe, adapted to be cut to length as a function of the application and usage needs, according to a generally modular design approach.

The market is pushing towards low-cost modules; therefore, the need is felt of implementing structures which are as simple and inexpensive as possible.

Various ribbon-shaped LED modules, e.g. of the flexible kind, which are currently available on the market are adapted to be employed with a constant voltage supply (e.g. 24 or 12 Vdc), with the light radiation sources (e.g. LED sources) grouped in strings which are connected in parallel, with every string including a certain number of sources connected in series, in order to optimize the efficiency of the module.

The power may be supplied e.g. via two electrically conductive lines (also named tracks or rails) extending along the module and providing the "poles" (e.g. positive and negative, or hot line and ground) in the lengthwise direction of the module.

Said solution exhibit advantages as well as drawbacks.

One advantage is the availability of power supply poles virtually at any position of the module, which may therefore be cut to length according to the application and usage needs, the corresponding possibility being given of a connection to a power supply.

Some of the disadvantages are:
- the difficulty in reducing the minimum cut length to a single source, because the single LED strings may hardly be interrupted;
- the presence of electrically conductive lines or rails all along the module imposes the use of supports which are wider than the physical size of the sources (e.g. LED sources), or the use of substrates, substantially similar to flexible printed circuit boards (Flexible Printed Circuits, FPCs), having a plurality of layers, so as to create the space for arranging the electrically conductive lines onto layers other than the layer of the electronic components; this may cause limitations as regards cost optimization;
- in order to provide the power supply electrical connection at a cutting point, it is necessary to use connectors having (at least) two poles, with consequent possible limitations in optimizing the costs of the applications for the end user.

Substantially similar observations in terms of positive and negative aspects may apply to rigid linear (e.g. LED) modules, which may be available either for a constant voltage or for a constant current supply. Also in this case, the power supply poles must be provided all along the module.

### Object and Summary

One or more embodiments aim at improving the solutions known in the art, e.g. as regards one or more of the previously outlined drawbacks.

According to one or more embodiments, said object may be achieved thanks to a mounting structure having the features set forth in the claims that follow.

One or more embodiments may also refer to a corresponding device as well as a corresponding method.

The claims are an integral part of the technical teaching provided herein with reference to the embodiments.

One or more embodiments may offer one or more of the following advantages:
- a simple electrical structure, the possibility being given of reducing production costs thanks to the lower cost of the material and to the higher number of modules, e.g. LED modules, which can be processed at the same time in the production line; such aspects are ideally compatible with low-cost applications;
- the solution may be applied both to rigid and to flexible ribbon-shaped modules, which may be obtained e.g. via reel-to-reel processes;
- possibility of reducing the width of the module to its minimum value (practically corresponding to the size of the light radiation sources), given that, at least in some embodiments, it is possible to omit electrically conductive lines having different polarities and extending along the module;
- modular design, the possibility being offered to cut the module to length according to the application and usage needs;
- possibility of reducing the supply voltage of a lighting installation by splitting e.g. a string of LEDs into several portions connected in parallel, the optional possibility being offered, irrespective of the separation point, of obtaining a nearly constant pitch among the light radiation sources.

### Brief Description of the Figures

One or more embodiments will now be described, by way of non-limiting example only, with reference to the annexed Figures, wherein:
- Figure 1 exemplifies one or more embodiments,
- Figure 2 exemplifies one or more embodiments,
- Figure 3 exemplifies one or more embodiments,
- Figure 4 exemplifies one or more embodiments, and
- Figures 5 to 7 exemplify various uses of embodiments.

It will be appreciated that, for simplicity and clarity of illustration, the various Figures may not be drawn to the same scale.

### Detailed Description

In the following description, various specific details are given to provide a thorough understanding of the exemplary embodiments according to the present specification. The embodiments may be practiced without one or several specific details, or with other methods, components, materials, etc. In other instances, well-known operations, materials or structures are not shown or described in detail in order to avoid obscuring some aspects of the embodiments.

Reference throughout this specification to "one embodiment" or "an embodiment" means that a particular feature, structure, characteristic described in connection with the embodiment is included in at least one embodiment. Thus, the possible appearances of the phrases "in one embodiment" or "in an embodiment" in various places throughout this specification are not necessarily all referring exactly to the same embodiment. Furthermore, particular features, structures, or characteristics may be combined in any suitable manner in one or more embodiments.

The headings provided herein are for convenience only, and therefore do not interpret the extent of protection or scope of the embodiments.

In the Figures, reference 10 generally denotes an electrically powered lighting device. One or more embodiments envisage the use of a lighting device employing electrically powered solid-state light radiation sources, such as LED sources L.

In one or more embodiments, device 10 (and specifically the mounting structure for sources L, which will be described in the following) may have an elongated shape, e.g. the shape of a flexible ribbon-like element (stripe) or a rigid or semi-rigid rod.

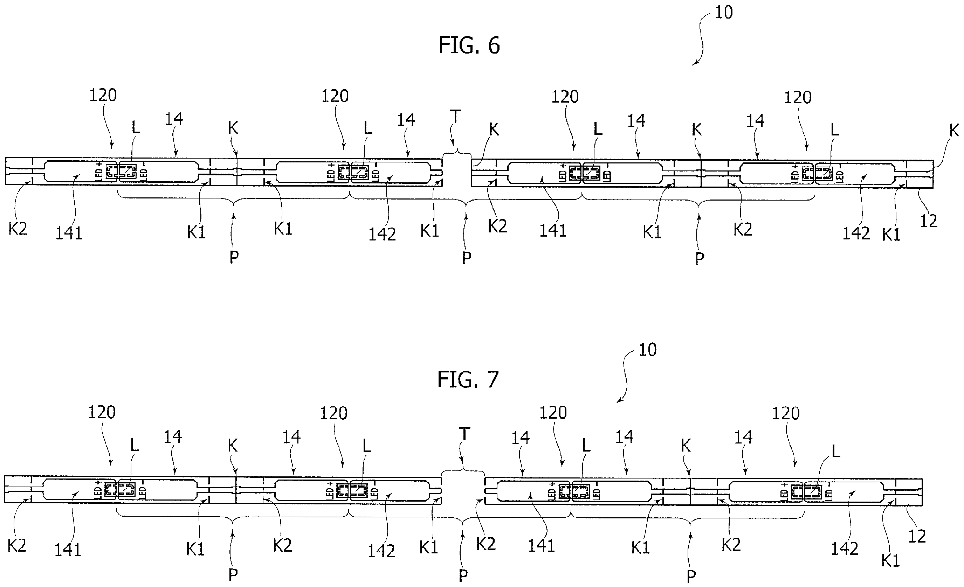

As far as the present instance is concerned, device 10 and said mounting structure may be considered as having indefinite length, and are adapted to be cut to length according to the application and usage needs, e.g. according to the criteria discussed in the following with reference to Figures 6 and 7.

In one or more embodiments, a device 10 as exemplified herein may include a mounting structure for sources L (in the following, for simplicity, reference will be mainly made to LED sources) including a ribbon-shaped or rod-shaped laminar structure 12, whereon there are provided, e.g. with a constant pitch, areas or positions 120 whereat sources L are destined to be mounted.

In one or more embodiments, the various mounting positions 120 may be connected to electrically conductive formations, generally denoted as 14.

In one or more embodiments, formations 14 may be implemented (according to known criteria) by etching, e.g. chemical or laser etching, a layer of electrically conductive material such as copper, applied on one of the sides of substrate 12. In one or more embodiments, in order to implement the electrically conductive formations 14 various technical solutions may be resorted to, such as e.g. the deposition of electrically conductive inks, or hybrid solutions involving etching/depositing conductive inks.

In one or more embodiments, formations 14 are adapted to be used in order to perform the power supply to sources L, e.g. by applying, to the power supply terminals of sources L (e.g. to the anode and the cathode of a LED source) a voltage drop from a voltage LED+ to a voltage LED-, adapted to respectively correspond to a direct voltage of 24V or 12 V (LED+) and a ground voltage (LED-).

Of course such values are merely exemplary, and do not limit the embodiments.

In one or more embodiments, the elements of the mounting structure - specifically, the mounting areas or positions 120 for the light radiation sources and the electrically conductive formations 14 associated thereto - may be considered as implementing a general modular approach, so that said structure may include a plurality of mounting units for the light radiation sources L, each unit being located between two electrical contact end pads respectively denoted as 141 and 142.

Said end pads 141, 142 are adapted to be used in order to apply a power supply corresponding to the previously described poles LED+ and LED-.

In one or more embodiments, the contact may take place (as known in itself) via connectors G (schematically shown in the Figures) which may include sliding contacts (e.g. in the case of bare modules) or piercing contacts (e.g. in the case of protected modules, having e.g. an IP protection degree), which are adapted to contact pads 141, 142 by piercing the protection covering of the module.

In one or more embodiments, the mounting units located between two end pads 141, 142 may include a different number of mounting positions 120 for corresponding light radiation sources L.

For example:

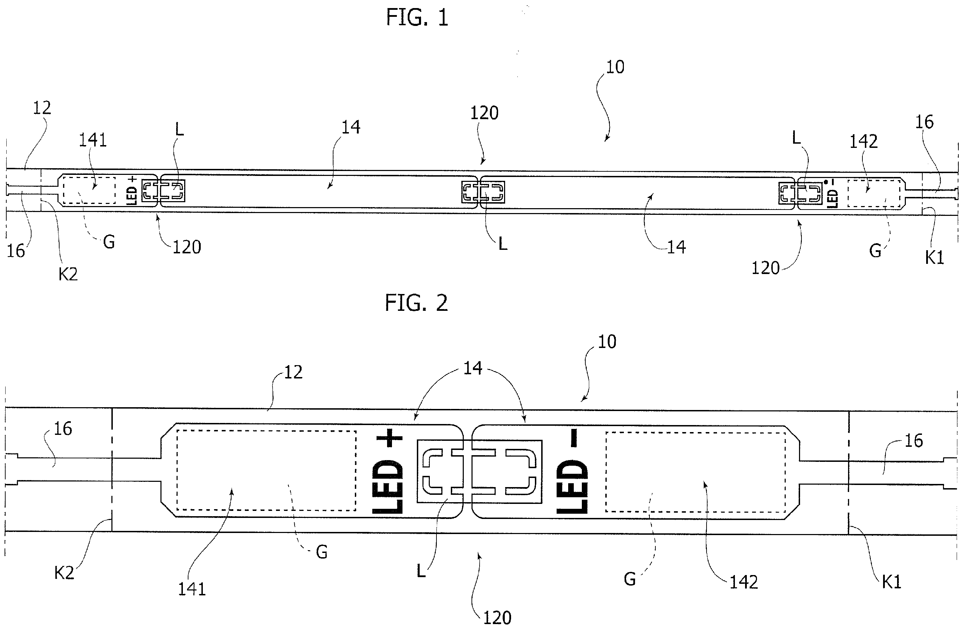

- Figure 1 exemplifies a unit including three mounting positions 120, located between two end pads 141, 142;
- Figure 2 exemplifies a basic mounting unit, including one mounting position 120 located between two end pads 141, 142;

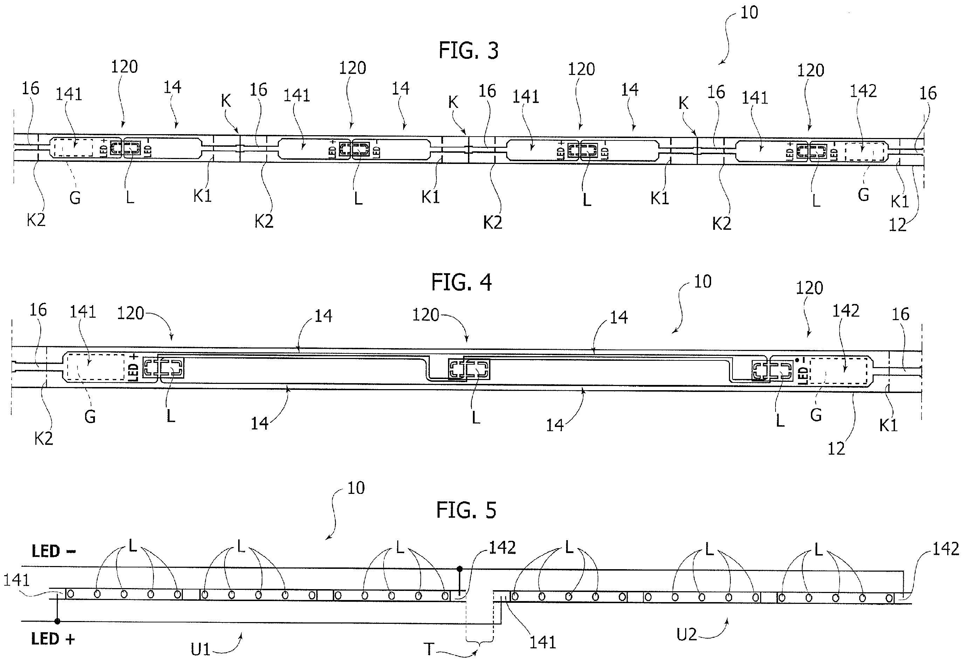

- Figure 3 exemplifies embodiments wherein four mounting positions 120 are located between two end pads 141, 142; and
- Figure 4 exemplifies embodiments wherein, in the same way as in Figure 1, three mounting positions 120 are located between two end pads 141, 142.

Figure 1 shows that, in the shown example, the various mounting positions 120 are arranged electrically in series with each other, between the end pads 141, 142.

From left to right, Figure 1 shows a first position 120 including two respective lands for the connection to the terminals of a respective source L, the first being connected to pad 141 and the second being connected to an electrically conductive formation (line) 14 extending towards a first land of the second position 120.

This second mounting position in turn includes a second land which is connected, through a further electrically conductive formation or line 14, to a first land of the third mounting position 120, in turn including a second land connected to the end pad 142.

In this way, the various sources L destined to be mounted in the positions 120 may be mutually connected in series between the end pads 141, 142.

In the case exemplified in Figure 4, on the other hand, in all (three) mounting positions 120 there is provided a first land (on the left with reference to the viewpoint of Figure 4) which is connected, through a respective (thin) formation or line 14, to the end pad 141, and a second land (on the right with reference to the viewpoint of Figure 4) which is connected, through a second formation or line 14, to the end pad 142.

In this way, the various light radiation sources L, mounted at the mounting positions 120, may be electrically connected in parallel with each other between end pads 141, 142.

Figure 4 moreover exemplifies that (with an approach which may be transferred also to the embodiments exemplified in other Figures) the thickness/width of some formations or lines, which in itself may be reduced to low values (e.g. 0.3-0.5 mm) in the presence of low currents (e.g. a few tens of milliAmpere), may be kept to a certain value - see the case of line 14 below in Figure 4 - so as to favour dissipation of the heat generated by the light radiation sources in operation.

It will be appreciated that the examples shown in Figure 1 (connection in series) and in Figure 4 (connection in parallel) may virtually be applied to any number of mounting positions 120 / radiation sources L.

Figure 3 exemplifies that, in one or more embodiments, a connection arrangement as exemplified in figure 1 may be achieved (with reference to the number, virtually chosen at will, of the mounting positions 120 and the light radiation sources L) by defining the mounting unit, across which the power supply LED+/LED-will be applied, as including any number of basic units as exemplified in Figure 2.

Moreover, the possibility is given of taking advantage, for example, of the possible presence (which may also be envisaged in embodiments as exemplified in Figure 1 and in Figure 4) of electrically conductive formations 16 which extend, as an electrical connection bridge, between mutually facing end pads 141, 142 of adjacent mounting units.

In one or more embodiments, formations 16 may be implemented in such a way that they may be interrupted (e.g. cut, or broken or severed by bending) at areas K, K1, K2 where substrate 12 (and therefore the mounting structure according to one or more embodiments) may be subjected to cutting, e.g. according to transverse lines.

In one or more embodiments, said areas or lines may be located at an intermediate position between two adjacent end pads 141, 142 (belonging to two different mounting units), e.g.:
- as single areas/lines extending in a middle position between two adjacent end pads 141, 142 (positions denoted as K in the Figures),
- as pairs of areas/lines located between two adjacent end pads 141, 142, each pair including two areas/lines in mirror symmetry on opposed bands with respect to the middle line/area K (positions denoted as K1, K2 in the Figures).

In one or more embodiments, substrate 12 and bridges 16 may be implemented in such a way that they may be severed/interrupted in a simple and easy fashion, e.g. they may be cut by scissors, at least in the case of flexible structures.

As stated in the foregoing, one or more embodiments may be applied both to flexible ribbon-shaped structures and to rigid rod-shaped structures.

In the case of rigid structures, pre-cut (or easy-tear) lines may be provided e.g. at the back (lower) surface or side of substrate 12, the bridges 16 being adapted to break e.g. as a consequence of bending.

In one or more embodiments, the light radiation sources (e.g. point-like sources), such as LED sources, may be connected so that the power supply poles (LED+, LED-) may be applied to the supply terminals of sources L, without the necessity of power supply formations (tracks or rails) extending in combination all along the length of the module, thus contributing to increasing the width of the module.

For example, in one or more embodiments, the electrically conductive formations 14 and specifically the end pads 141, 142 may occupy more than half, up to 75% or more, of the width across the length of substrate 12.

Conversely, this enables a width decrease of substrate 12, down to a value which virtually corresponds to the related dimension (width) of sources L.

At any rate, even without excessive reductions, in one or more embodiments the width of substrate 12 (and therefore the width of device 10 on the whole) may be reduced to a value approximately amounting to half the values of current solutions.

One or more embodiments may therefore lead to a reduction of the amount of material used for substrate 12 (e.g. an FPC structure in the case of flexible designs, or a PCB structure in the case of rigid designs), with a consequent cost reduction. Said effect may also be linked to the use, for the electrically conductive formations 14, of only one side of the structure (e.g. FPC or PCB).

The possible reduction of the width mentioned in the foregoing may be beneficial also as regards the possibility of processing in parallel a higher number of structures/modules included in a panel (in the case of rigid modules) or in a flexible bobbin or reel (in the case of flexible structures, which are processed e.g. with reel-to-reel techniques) before the single structures/modules are separated from each other.

As stated in the foregoing, one or more embodiments may envisage grouping light radiation sources into single mounting units (including one or more light radiation sources) located between end pads 141, 142, which define the single unit.

The length of the final module which may be achieved with said units may be determined as a function of the application and usage needs, simply by severing the structure (optionally with sources L already mounted thereon) at lines such as lines K, K1, K2.

This may take place by interrupting at such lines both the substrate 12 and the bridge-like formations 16, which may enable a mutual cascade connection of a plurality of units, e.g. within a longer structure (e.g. a bobbin or a reel).

As can be observed e.g. by comparing Figure 1 and Figure 4, one or more embodiments enable the connection of a plurality of light radiation sources L either in series (in the example of Figure 1) or in parallel with each other (in the example of Figure 4).

Figure 5 exemplifies the possibility of connecting a plurality of mounting units, and refers by way of example to two units, respectively denoted as U1 and U2, each located between two end pads 141 and 142, and each including a given number of light radiation sources L electrically connected in series with each other. The various units (e.g. U1, U2) may be connected in parallel with each other, e.g. with the pole LED+ connected to the pads 141 of the various units and the pole LED- connected to the pads 142 of the various units, as schematically shown in Figure 5.

Solutions as exemplified in Figure 5 may be used e.g. if it is necessary to employ rather long linear lighting modules in the presence of a limited available supply voltage.

Figure 5 exemplifies the possibility of severing said installation into a plurality of modular units U1, U2 arranged in sequence one after the other and connected in parallel, the possibility being given of leaving a separation gap T in order to favour the achievement of electrical insulation between two mutually facing end pads 142 (unit U1) and 141 (unit U2), which are respectively destined to be brought to the levels LED- and LED+.

This procedure may, at least theoretically, originate an alteration of the pitch between the light radiation sources L: at the separation gap T a sort of "hole" might then appear, i.e. an area of reduced lighting due to the absence of light radiation sources at the separation gap.

Figures 6 and 7 exemplify the possibility of overcoming said drawback by severing the mounting structure (and generally the device) at:
- an area/line K1 (or K2) and an adjacent area/line K (Figure 6),
- two adjacent areas/lines K1, K2,
the consequent possibility being given of keeping a constant pitch (denoted as P) between adjacent light radiation sources L.

One or more embodiments may therefore concern a mounting structure for electrically powered light radiation sources (e.g. L), the structure including an elongated substrate (e.g. 12) having therealong a distribution of mounting units for electrically powered light radiation sources, wherein:
- said mounting units include first (e.g. 141) and second (e.g. 142) electrical contact end pads, between which it is possible to apply a power supply (e.g. LED+, LED-),
- at least one light radiation source mounting position (e.g. 120) is provided between said first and second electrical contact end pads, and
- said elongated substrate includes, between mutually facing electrical contact end pads of adjacent mounting units in said distribution of mounting units, severable substrate portions (e.g. K; K1, K2).

One or more embodiments may include electrically-conductive formations (e.g. 16) extending across respective severable substrate portions, thereby connecting bridge-like mutually facing electrical contact end pads of adjacent mounting units in said distribution of mounting units; said electrically-conductive formations being adapted to be interrupted as a result of said respective substrate portions being severed.

In one or more embodiments, said mounting units may include a single light radiation source mounting position, said single position including first and second light radiation source mounting lands in electrical contact with said first and said second contact end pads, respectively.

In one or more embodiments, said mounting units may include a plurality of light radiation source mounting positions, said positions including respective first and second light radiation source mounting lands, wherein said plurality of light radiation source mounting positions are mutually connected in series (see e.g. Figure 1) between said first and said second contact end pads.

In one or more embodiments, said mounting units may include a plurality of light radiation source mounting positions, said positions including respective first and second light radiation source mounting lands, wherein said plurality of light radiation source mounting positions are mutually connected in parallel (see e.g. Figure 4) between said first and said second contact end pads.

In one or more embodiments, said elongated substrate may have a width across its length and said first and said second electrical contact end pads extend over more than a half, and preferably at least over 75%, of said width.

In one or more embodiments, a lighting device (e.g. 10) may include:
- a mounting structure according to one or more embodiments, and
- electrically powered light radiation sources, optionally of the LED type, at said light radiation source mounting positions in said distribution of mounting units.

In one or more embodiments, a method of using a support structure according to one or more embodiments may include:
- severing the structure at at least one of said severable substrate portions, separating from the structure at least one mounting unit in said distribution of mounting units, and
- providing (before or after said severing) electrically powered light radiation sources at said at least one light radiation source mounting position of said at least one mounting unit separated from the structure.

One or more embodiments may include:
- severing the structure at at least one pair of said severable substrate portions, separating from the structure at least two mounting units (e.g. U1, U2) in said distribution of mounting units,
- arranging the at least two mounting units separated from the structure at a distance (e.g. T) therebetween, by keeping a constant separation pitch (e.g. P) between the light radiation source mounting positions in said units.

In one or more embodiments, said light radiation sources may include LED sources.

Without prejudice to the basic principles, the implementation details and the embodiments may vary, even appreciably, with respect to what has been described herein by way of non-limiting example only, without departing from the extent of protection.

The extent of protection is determined by the annexed claims.

## Claims

1. A mounting structure for electrically-powered light radiation sources (L), the structure including an elongated substrate (12) having therealong a distribution of mounting units for electrically-powered light radiation sources (L), wherein:
- said mounting units include first (141) and second (142) electrical contact end pads for application of an electrical supply (LED+, LED-),
- at least one light radiation source mounting position (120) is provided between said first (141) and second (142) electrical contact end pads, and
- said elongated substrate (12) includes, between mutually facing electrical contact end pads of adjacent mounting units in said distribution of mounting units, severable substrate portions (K; K1, K2).

2. The mounting structure of claim 1, including electrically-conductive formations (16) extending across respective severable substrate portions (K; K1, K2) to connect bridge-like mutually facing electrical contact end pads (141, 142) of adjacent mounting units in said distribution of mounting units; said electrically-conductive formations (16) interruptible as a result of said respective substrate portions (K; K1, K2) being severed.

3. The mounting structure of claim 1 or claim 2, wherein said mounting units include a single light radiation source mounting position (120), said single position (120) including first and second light radiation source mounting lands in electrical contact with said first (141) and said second (142) electrical contact end pads, respectively.

4. The mounting structure of claim 1 or claim 2, wherein said mounting units include a plurality of light radiation source mounting positions (120), said positions (120) including respective first and second light radiation source mounting lands, wherein said plurality of light radiation source mounting positions are mutually connected in series between said first (141) and said second (142) electrical contact end pads.

5. The mounting structure of claim 1 or claim 2, wherein said mounting units include a plurality of light radiation source mounting positions (120), said positions (120) including respective first and second light radiation source mounting lands, wherein said plurality of light radiation source mounting positions are mutually connected in parallel between said first (141) and said second (142) electrical contact end pads.

6. The mounting structure of any of the previous claims, wherein said elongated substrate (12) has a width across its length and said first (141) and said second (142) electrical contact end pads extend over more than a half, and preferably at least over 75%, of said width.

7. A lighting device (10), including:
- a mounting structure according to any of claims 1 to 6, and
- electrically-powered light radiation sources, preferably of the LED type (L), at said light radiation source mounting positions (120) in said distribution of mounting units.

8. A method of using a support structure according to any of claims 1 to 6, the method including:
- severing the structure at at least one of said severable substrate portions (K; K1, K2), separating from the structure at least one mounting unit in said distribution of mounting units, and
- providing electrically-powered light radiation sources (L) at said at least one light radiation source mounting position in said at least one mounting unit separated from the structure.

9. The method of claim 8, including:
- severing the structure at at least one pair of said severable substrate portions (K; K1, K2), separating from the structure at least two mounting units (U1, U2) in said distribution of mounting units,
- arranging the at least two mounting units (U1, U2) separated from the structure at a distance (T) therebetween by keeping a constant separation pitch (P) between the radiation source mounting positions (120) in said units.

10. The method of claim 8 or claim 9, wherein said light radiation sources (L) include LED sources.
